# EUROPÄISCHE PATENTSCHRIFT

(11) **EP 2 695 500 B1**
(45) Veröffentlichungstag und Bekanntmachung des Hinweises auf die Patenterteilung: **04.03.2015**
(21) Anmeldenummer: 12710702.7
(22) Anmeldetag: 21.03.2012
(51) Int. Cl.: H05K 7/14

(54) **VORRICHTUNG ZUM SANFTANLAUF**
GENTLE-START-UP DEVICE
DISPOSITIF DE DÉMARRAGE EN DOUCEUR

(30) Priorität: 01.04.2011 DE 102011001731
(43) Veröffentlichungstag der Anmeldung: 12.02.2014
(73) Patentinhaber: IGEL Electric GmbH, 48324 Sendenhorst (DE)
(72) Erfinder: WESTHOFF, Jörg, 48324 Sendenhorst (DE)
(74) Vertreter: Moser Götze & Partner Patentanwälte mbB
(86) Internationale Anmeldenummer: PCT/EP2012/054937
(87) Internationale Veröffentlichungsnummer: WO 2012/130671

(56) Entgegenhaltungen:
- EP-A2- 1 942 712
- WO-A1-2010/086364
- DE-A1-102007 030 344

## Beschreibung

Die Erfindung betrifft eine Vorrichtung zum Sanftanlauf mit einem Gehäuse und mit mindestens einem in das Gehäuse ein- und ausschiebbaren Einschub, wobei das Gehäuse mit entsprechenden übereinander und/oder hintereinander angeordneten Aufnahmen für die modularen Einschübe versehen ist, so dass die modularen Einschübe wahlweise in Höhen- oder Tiefen-Richtung des Gehäuses einschiebbar und ggf. mit weiteren identischen modularen Einschüben in Reihe oder parallel geschaltet werden können.

Sanftanlasser (sogenannte soft starter) werden Maßnahmen zur Leistungsbegrenzung beim Einschalten eines elektrischen Gerätes, meist eines elektrischen Motors, verwendet. Zum einen wird dadurch der Einschaltstrom des Gerätes verringert (Einschaltstrombegrenzung), bei großen Lasten wird damit auch das Ansprechen eines Leitungsschutzschalters oder ein starker Spannungseinbruch der Netzspannung vermieden. Zum anderen werden die von Motoren angetriebenen mechanischen Komponenten vor allzu großen Drehmomenten und Beschleunigungen geschützt.

Die Eigenschaften eines Sanftanlassers unterscheiden sich von denen anderer Anlassmethoden (direktes Einschalten, Stern-Dreieck-Schaltung oder Frequenzumrichter). Er verfügt im Hauptschaltkreis meist über Thyristoren, wobei die Motorspannung über eine elektronische Steuerung geregelt wird. Beim Sanftanlasser wird die Tatsache ausgenutzt, dass eine geringe Motorspannung beim Anlassen auch einen geringen Anlaufstrom und ein geringes Anlaufmoment bewirkt. Während des ersten Teils des Anlassvorgangs ist die Spannung am Motor so gering, dass dadurch nur das Spiel zwischen den Zahnrädern geregelt bzw. die Antriebsriemen oder -ketten usw. gestrafft werden können. Dadurch werden also unnötige ruckartige Bewegungen beim Anlaufen vermieden. Allmählich wird die Spannung und das Drehmoment erhöht, so dass die Maschine zu beschleunigen beginnt.

Einer der Vorteile dieser Anlassmethode ist die Möglichkeit, das Drehmoment entsprechend desgenauen Bedarfs zu regeln, gleich ob die Anwendung belastet ist oder nicht. Im Prinzip steht nur das benötigte Anlaufmoment zur Verfügung; der große Unterschied besteht jedoch darin, dass das Anlassverfahren für die angetriebene Maschine wesentlich schonender ist, wodurch die Wartungskosten niedrig gehalten werden können.

Eine weitere Funktion des Sanftanlassers ist die Sanftauslauffunktion. Diese kann auch mit einer Bremsfunktion erweitert werden.

Ein Sanftanlasser besteht im Allgemeinen aus einigen wenigen Hauptkomponenten wie Leiterplatte, Kühlrippen, Thyristoren, Lüfter und Gehäuse (aus Kunststoff oder Metall). Die Steuerungsschaltung kann digital, analog oder in einer Kombination beider Bauformen ausgeführt sein. Das Ausgabesignalrelais kann als Typ mit fester Funktion oder frei programmierbar sein.

Allerdings werden die Sanftanlasser meist spezifisch auf eine Anwendung hin mit einer bestimmten Anzahl von Thyristoren und sonstigen Komponenten aufgebaut, um die geforderten Spannungs- und Strombereiche und sonstigen Anforderungen abzudecken.

Üblicherweise werden Sanftanlasser in sogenannten Schaltschränken eingebaut. Dies bedingt jedoch im Fehlerfall eine komplexe Reparatur und Wartung sowie aufwendige Fehlersuche, währenddessen der Betrieb unterbrochen ist.

Wie aus der eigenen WO 2010/086364 A1 bekannt, kann zur Verbesserung mit Einschüben gearbeitet werden. Aus der WO 2010/086364 A1 ist z.B. eine Mittel- oder Hochspannungsschaltanlage mit einem Anlagengehäuse, mit einem Niederspannungssteuerteil, mit einem Kabelanschlussraum, mit einem Sammelschienensystem und mit einer einzelnen in das Anlagengehäuse ein- und ausschiebbaren Einschubeinheit für unterschiedlichste Leistungsteile bekannt. Als Leistungsteile kommen daher auch Sanftanlasserschaltungen in Betracht. Das Anlagengehäuse ist als ein vorne offenes äußeres Gehäuse ausgebildet und die einzelne Einschubeinheit ist derart ausgestaltet, dass diese in das Anlagengehäuse ein- und ausschiebbar ist, und die Einschubeinheit eine fest verbaute Vordertür zum hermetischen Abschluss der durch das Anlagengehäuse gebildeten Öffnung aufweist, wobei das Einschubteil neben dem Leistungsteil den Niederspannungssteuerteil aufweist.

Man versucht aber nach wie vor, die Reparatur und Wartung zu vereinfachen und beschleunigen, in dem man modulare Phaseneinschübe einsetzt, die durch Austausch eine schnellere Wiederinbetriebnahme ermöglichen.

Aus der EP 1 942 712 A2 ist z.B. ein modularer Softstarter bekannt, bei dem pro Phase eine modulare Baueinheit aus Kunststoff vorgesehen ist, die sich entweder der Höhe oder der Breite nach stapeln lässt. Dabei sind allerdings die Treiberbausteine und weitere periphere Elektronik außerhalb der Baueinheit an zusätzlichen Strukturen angebracht in Abhängigkeit von der gewählten Stapelanonrdnung.

Aus der DE 10 2007 030 344 A1 ist ein Softstarter bekannt, der ein Gehäuse aufweist, in das ein eine dreiphasige Thyristor-Anordnung aufweisender Einschub ein- und ausschiebbar ist.

Demgegenüber besteht die Aufgabe der vorliegenden Erfindung einen Sanftanlasser bereitzustellen, bei dem die Wartung und Reparatur sowie Herstellung schneller, einfacher und kostengünstiger möglich ist.

Diese Aufgabe wird durch die in Anspruch 1 wiedergegebene Vorrichtung zum Sanftanlauf gelöst.

Dadurch, dass pro Spannungsebene je ein modularer Einschub vorgesehen ist, der eine dreiphasige Thyristor-Anordnung aufweist, ist es möglich, die modularen Einschübe universell für eine bestimmte Spannung auszulegen. Somit muss lediglich ein kostengünstiger modularer Einschub bevorratet werden. Da in der Regel ohnehin drei Phasen zur Sanftanlasssteuerung verwendet werden, ist der Austausch noch einfacher, da eine umständliche Verkabelung im Gegensatz zur EP 1 942 712 A2 entfällt, da keine einzelnen Phasen "verdrahtet" werden müssen. Es ist also pro Spannungsebene nur ein einzelnes Modul nötig.

Die gebräuchlichsten Spannungen sind ca. 3,3 kV, ca. 6,6 kV und ca. 10 kV. So wird ein modularer Einschub für eine Spannung von ca. 3,3 kV ausgelegt werden. Ganz besonders bevorzugt enthalten die modularen Einschübe dabei jeweils nur ein 3,3 kV Thyristorpaar pro Phase. So kann z.B. eine Gesamtspannung von ca. 10 kV durch Verwendung von drei in Reihe geschalteten 3,3 kV modularen Einschüben abgebildet werden.

Somit müssen nicht unterschiedlichste Komponenten bevorratet werden, sondern lediglich ein universell einsetzbares Teil und dieses in kleineren Stückzahlen.

In einer bevorzugten Ausführungsform umfasst die Thyristor-Anordnung eines Einschubs für jede der drei Phasen jeweils ein antiparallel verschaltetes Paar Thyristoren, wobei jeder Thyristor zwischen zwei Wärmeableitblechen angeordnet ist und die beiden Thyristoren einer Phase sich ein Wärmeableitblech teilen. Somit kann eine besonders kompakte Bauform bei niedrigen Herstellungskosten erzielt werden. Insbesondere können die äußeren Abmessungen der modularen Einschübe so klein gehalten werden, dass eine 19 Zoll Bauweise trotz ausreichender Luftabstände und Kühlung eingehalten werden kann.

Ganz besonders bevorzugt ist es dabei, wenn alle Thyristoren eines modularen Einschubs bzw. einer Spannungsebene in einer linearen stapelförmigen Anordnung von einer gemeinsamen Spannvorrichtung gehalten werden. Insbesondere verläuft die Anordnung quer zur Einschubrichtung der modularen Einschübe in das Anlagengehäuse. Somit kann eine wenig tiefe Bauweise eingehalten werden und es können sogar zwei modulare Einschübe hintereinander in übliche Anlagengehäuse eingesetzt werden.

Vorzugsweise befinden sich zwischen den Wärmeableitblechen zweier benachbarter Phasen isolierende Platten, insbesondere Verbundwerkstoffplatten. Diese unterstützen die kompakte lineare Bauform mit einer gemeinsamen Spannvorrichtung.

Aufgrund der sehr kompakten Bauweise der modularen Einschübe ist ein besonderes Augenmerk auf die Kühlung zu legen. Es hat sich herausgestellt, dass, wenn die modularen Einschübe mit elektrisch isolierenden und gleichzeitig wärmeleitenden (Abdeck)-Platten ummantelt sind, insbesondere oben und/oder unten abgedeckt sind, besonders bevorzugt im Bereich der Thyristor-Anordnung selber, eine gute Kühlung erreichbar ist. Zusätzlich sind Öffnungen für den Luftaustausch oberhalb/unterhalb der Wärmeableitbleche in der Ummantelung der Einschübe vorgesehen. Die Platten können ebenso die vordere und hinter Abdeckung ausbilden. Dabei kann sogar eine L-förmige Platte gleichzeitig die untere Abdeckung und die vordere Abdeckung ausbilden. Die elektrisch isolierenden und gleichzeitig wärmeleitenden Platten können keramische Platten sein.

Aufgrund der Nähe der spannungsbeaufschlagten Teile zueinander ist es wichtig, dass die Abdeck-Platten mit den isolierenden Platten gegen elektrischen Übersprung dichtend verbunden sind, so dass es nicht zu einem Überschlag der Spannung und somit zu einem Lichtbogen kommt. Dazu können Fugen der aneinander grenzenden Platten luftdicht verfugt und/oder verschraubt werden. Dies kann z.B. durch Vergießen mit Kunstharz erreicht werden.

Sinnvoll ist es, wenn die modularen Einschübe schubladenartig ausgebildet sind und sich somit leicht tauschen lassen. Daher ist es ebenfalls sinnvoll, wenn die elektrischen Ein- und Ausgangsanschlüsse (bzw. Stromschienen) in Einschubrichtung am hinteren Ende des modularen Einschubs angeordnet sind und sich somit beim Einschieben bzw. Ausziehen von alleine in die Kontaktstellung bewegen bzw. aus ihr heraus bewegen.

Die direkt dem Sanftanlasser zugeordnete periphere Elektronik, wie Spannungsversorgung, Zündelektronik und Snubber etc., sind vorzugsweise auf modularen Platinen innerhalb des modularen Einschubs angeordnet. Somit lassen sich diese bei einem Defekt austauschen.

Besonders bevorzugt ist es, wenn die Zündelektronik jeweils im vorderen Bereich der modularen Einschübe in Einschubrichtung vor der Thyristor-Anordnung angeordnet ist, und entsprechend, wenn die Snubber (die Reihenschaltungen eines Kondensators mit einem Widerstand) im hinteren Bereich der modularen Einschübe in Einschubrichtung hinter der Thyristor-Anordnung angeordnet ist und ggf. dabei mit Hilfe von Isolatoren an die Stromschienen angebunden sind.

Aufgrund der kompakten Bauweise ist es möglich, die Spannungsversorgung für die Zündelektronik in den Einschub zu integrieren, insbesondere seitlich neben der Thyristor-Anordnung gut zugänglich anzuordnen.

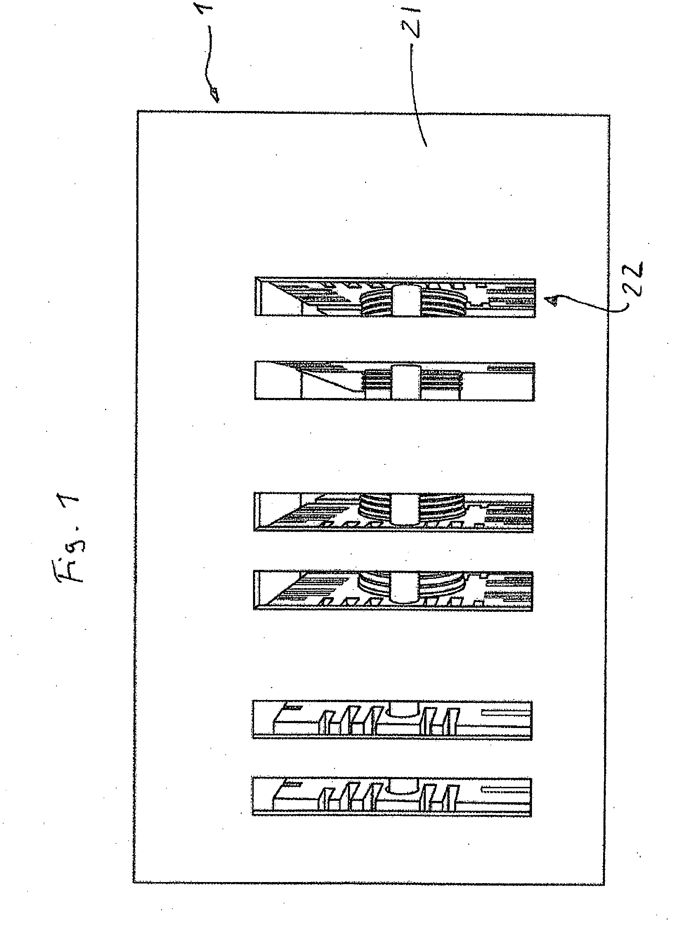

Weitere Details der Erfindung ergeben sich aus der nachfolgenden Beschreibung eines Ausführungsbeispiels anhand der Zeichnung, in der
- Fig. 1: eine Draufsicht von oben auf einen modularen Einschub;

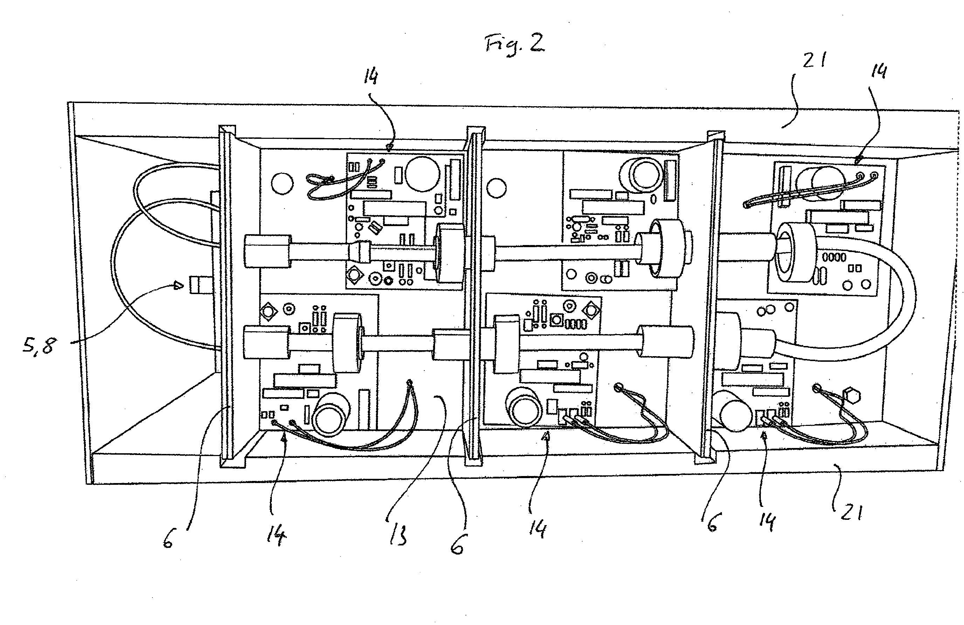

- Fig. 2: eine Ansicht von vorne auf den modularen Einschub aus Figur 1;

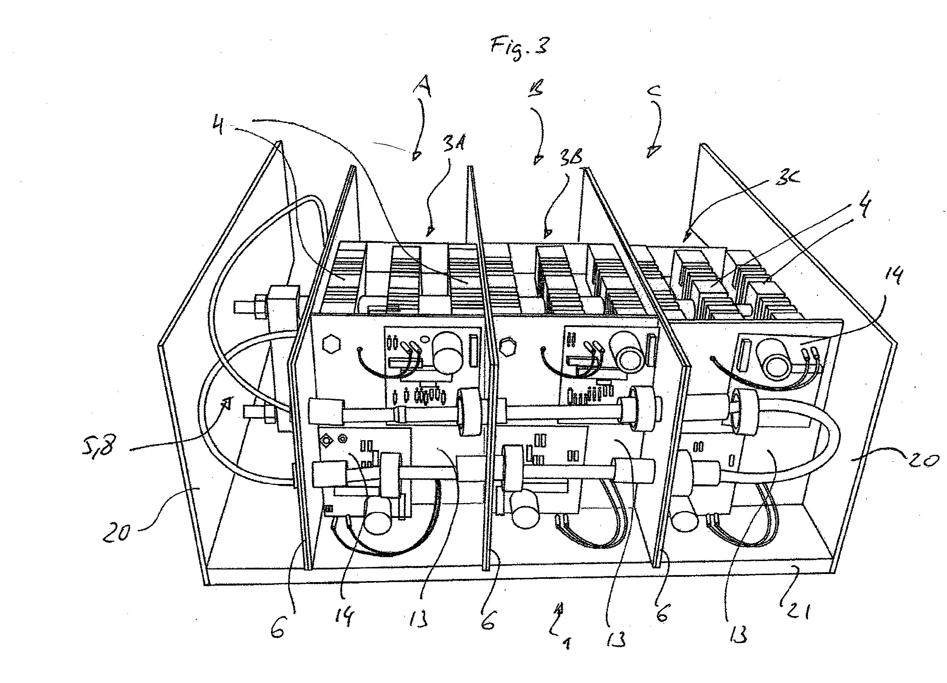

- Fig. 3 Figur 1;: eine perspektivische Ansicht von vorne auf den modularen Einschub aus
- Fig. 4: eine weitere perspektivische Ansicht von vorne und schräg oben auf den modularen Einschub aus Figur 1;
- Fig. 5: eine Draufsicht von oben auf den modularen Einschub aus Figur 1 ohne Abdeckung im Bereich der Thyristor-Anordnung und
- Fig. 6: eine perspektivische Ansicht von hinten auf eine Phase des modularen Einschubs aus Figur 1 im Bereich der Stromschienen.

In den Figuren ist ein als Ganzes mit 1 bezeichneter modularer Einschub einer Vorrichtung zum Sanftanlauf dargestellt, der in eine entsprechende (nicht dargestellte) Aufnahme eines Gehäuses, wie einem Rack, einschiebbar ist.

Der modulare Einschub 1 ist jeweils für eine Spannungsebene ausgelegt und umfasst dazu jeweils eine dreiphasige Thyristor-Anordnung 2.

Die Thyristor-Anordnung 2 des Einschubs umfasst für jede der drei Phasen A, B, C jeweils ein antiparallel verschaltetes Paar 3A, B, C Thyristoren, wobei jeder Thyristor 3A1, 3A2, 3B1, 3B2, 3C1, 3C2 zwischen zwei Wärmeableitblechen 4 angeordnet ist und die beiden Thyristoren 3A1 und 3A2 bzw. 3B1 und 3B2 bzw. 3C1 und 3C2 einer Phase sich ein Wärmeableitblech 4 teilen.

Alle Thyristoren werden dabei in einer linearen stapelförmigen Anordnung von einer gemeinsamen Spannvorrichtung 5 gehalten, die quer zur Einschubrichtung verläuft. Dabei sind zwischen den Wärmeableitblechen 4 zweier benachbarter Phasen A, B bzw. B, C isolierende Verbundwerkstoffplatten 6 angeordnet.

Die Spannvorrichtung 5 besteht aus zwei parallel verlaufenden Gewindestangen 7 aus Isoliermaterial, die am Kopf 8 bzw. Fuß 9 quer verlaufende Blöcke aus Federstahl durchgreifen und dort verschraubt sind. Die Gewindestangen 7 durchgreifen jeweils die Wärmeableitbleche 4 und Verbundwerkstoffplatten 6, wozu diese jeweils mit entsprechenden Bohrungen 10 bzw. 11 versehen sind.

In den Zwischenräumen sind die Gewindestangen 7 mit einer zusätzlichen Isolierung 12 versehen.

Vor (in Einschubrichtung besehen) der Thyristor-Anordnung 2 sind ebenfalls Verbundwerkstoffplatten 13 zur Isolierung vorgesehen. An diesen isolierenden Verbundwerkstoffplatten 13 ist jeweils die Zündelektronik 14

Die Wärmeableitbleche 4 der antiparallel verschalteten Thyristoren 3A1 und 3A2 bzw. 3B1 und 3B2 bzw. 3C1 und 3C2 einer Phase sind jeweils miteinander leitend über eine Querverbindung 16 verbunden.

In Einschubrichtung am hinteren Ende des modularen Einschubs 1 sind die elektrischen Ein- und Ausgangsanschlüsse bzw. Stromschienen 15 angeordnet, so dass diese beim Einschieben des Einschubs die entsprechenden Kontaktstellen kontaktieren. Die Stromschienen 15 sind direkt über die Wärmeableitbleche 4 angeschlossen.

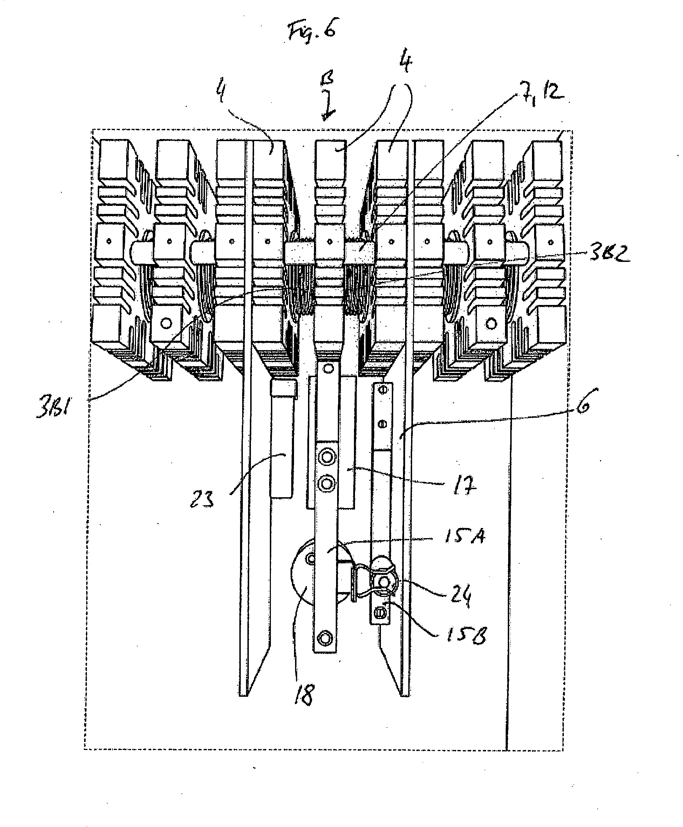

Dabei ist die Ausgangs-Stromschiene 15A am mittleren Wärmeableitblech 4 und die Eingangs-Stromschiene 15B am rechten (in Blickrichtung) äußeren Wärmeableitblech 4 angeschlossen (vgl. Figur 6).

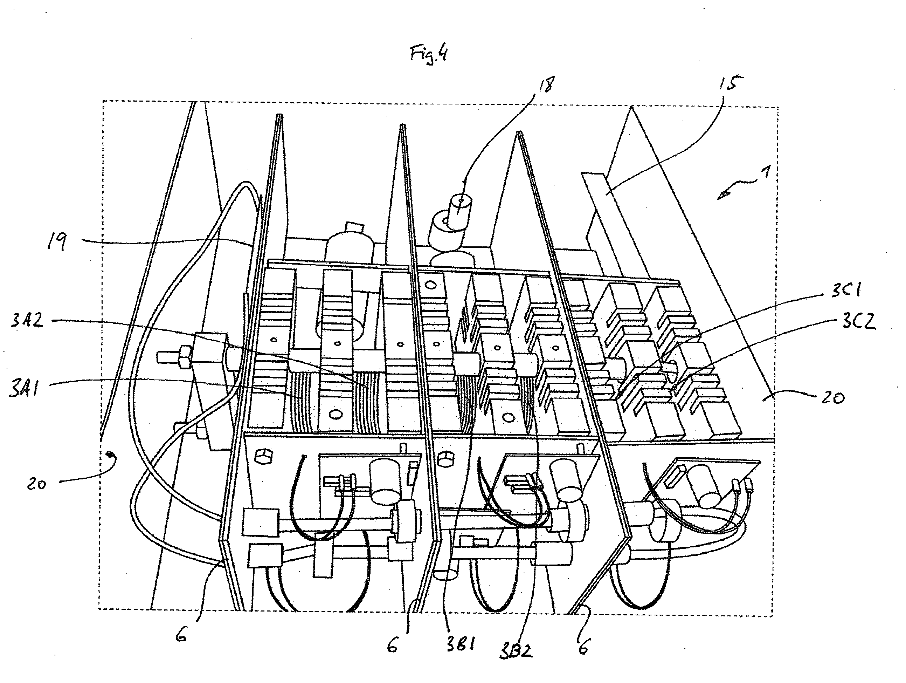

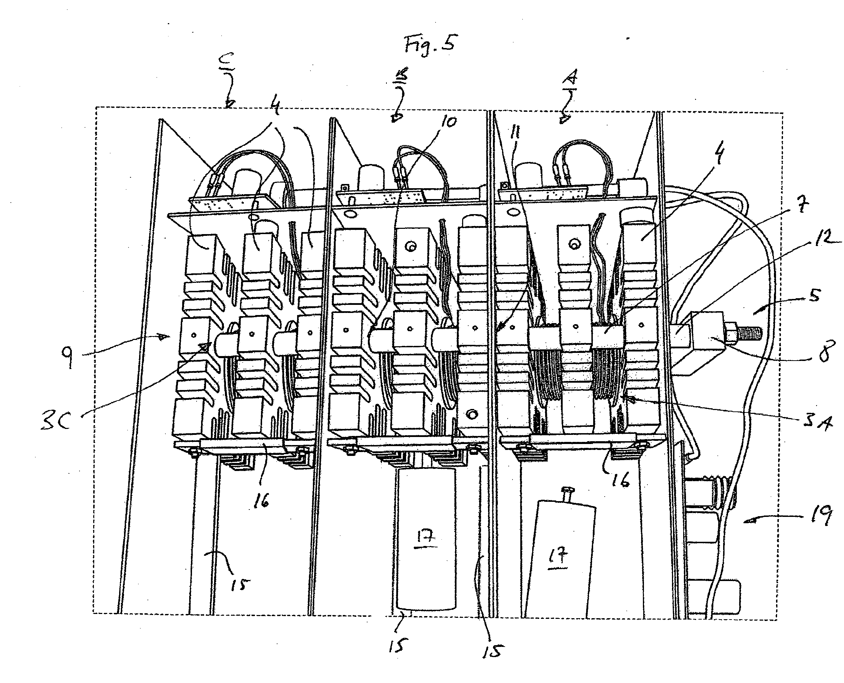

In Einschubrichtung hinter der Thyristor-Anordnung 2 sind jeweils die Snubber-Kondensatoren 17 im hinteren Bereich der modularen Einschübe 1 angeordnet. In den Figuren 4 und 5 sind lediglich die Snubber-Kondensatoren 17 für die Phasen A und B prinzipiell ohne Verschaltung gezeigt.

Die Snubber-Kondensatoren 17sind über Stütz-Isolatoren 18 an die Stromschienen 15A angebunden (vgl. Figur 6). In Reihe mit dem jeweiligen Snubber-Kondensator 17 ist der entsprechende Snubber-Widerstand 23 verschaltet (in Figur 6 ist zur besseren Übersicht die "Verdrahtung" nicht dargestellt).

An der Eingangs-Stromschiene 15B ist zudem eine Parallelwiderstand 24 vorgesehen.

Die Spannungsversorgung 19 für die Zündelektronik ist seitlich neben der Thyristor-Anordnung 2 angeordnet und mit der Zündelektronik 14 verdrahtet.

Die Spannungsversorgung 19 ist an einer der Seitenwände 20 des Einschubs 1 befestigt, die ebenfalls jeweils aus Verbundwerkstoff bestehen.

Als obere und untere Abdeckung weist der modulare Einschub 1 jeweils elektrisch isolierende und gleichzeitig wärmeleitende keramischen Platten 21 auf, die oberhalb bzw. unterhalb des Bereichs der Thyristor-Anordnung 2 angeordnet sind.

Zur besseren Wärmeabfuhr sind die keramischen Platten 21 mit Lüftungsschlitzen 22 versehen, die entsprechend oberhalb bzw. unterhalb der Thyristoren angeordnet sind.

Um einen Überschlag elektrischer Spannung von einer Phase auf die nächste zu verhindern, sind die keramischen Platten 21 mit den isolierenden Verbundwerkstoffplatten 13 gegen elektrischen Überschlag durch Vergießen der entsprechenden Spalten mit Harz abgedichtet.

## Patentansprüche

1. Vorrichtung zum Sanftanlauf mit einem Gehäuse und mit mindestens einem in der eine dreiphasige Thyristor-Anordnung (2) aufweist, das Gehäuse ein- und ausschiebbaren Einschub (1), **dadurch gekennzeichnet, dass** das Gehäuse mit entsprechenden übereinander und/oder hintereinander angeordneten Aufnahmen für die modularen Einschübe (1) versehen ist, so dass die modularen Einschübe wahlweise in Höhen- oder Tiefen-Richtung des Gehäuses einschiebbar sind und jeder modularer Einschub zur Bereitstellung einer Spannung vorgesehen ist, so dass pro Spannungsebene nur ein einzelnes Modul nötig ist und dass jeder Einschub ggf.
mit weiteren identischen modularen Einschüben (1) in Reihe oder parallel geschaltet werden kann, um eine Gesamtspannung abzubilden.

2. Vorrichtung nach Anspruch 1, **dadurch gekennzeichnet, dass** die Thyristor-Anordnung (2) eines Einschubs (1) für jede der drei Phasen (A, B, C) jeweils ein antiparallel verschaltetes Paar Thyristoren (3A1, 3A2; 3B1, 3B2; 3C1, 3C2) umfasst, wobei jeder Thyristor (3A1, 3A2, 3B1, 3B2, 3C1, 3C2) zwischen zwei Wärmeableitblechen (4) angeordnet ist und die beiden Thyristoren (3A1, 3A2; 3B1, 3B2; 3C1, 3C2) einer Phase (A; B; C) sich ein Wärmeableitblech (4) teilen.

3. Vorrichtung nach Anspruch 1 oder 2, **dadurch gekennzeichnet, dass** alle Thyristoren (3A1, 3A2, 3B1, 3B2, 3C1, 3C2) einer Spannungsebene in einer linearen stapelförmigen Anordnung von einer gemeinsamen Spannvorrichtung (5) gehalten werden.

4. Vorrichtung nach Anspruch 3, **dadurch gekennzeichnet, dass** zwischen den Wärmeableitblechen (4) zweier benachbarter Phasen (A, B; B; C) isolierende Platten (6), insbesondere Verbundwerkstoffplatten, angeordnet sind.

5. Vorrichtung nach einem der vorhergehenden Ansprüche, **dadurch gekennzeichnet, dass** die modularen Einschübe (1) mit elektrisch isolierenden und gleichzeitig wärmeleitenden Platten (21) ummantelt sind, insbesondere oben und/oder unten abgedeckt sind, besonders bevorzugt im Bereich der Thyristor-Anordnung (2), und diese Platten (21) mit den isolierenden Platten (6) gegen elektrischen Überschlag dichtend verbunden sind.

6. Vorrichtung nach Anspruch 5, **dadurch gekennzeichnet, dass** die elektrisch isolierenden und gleichzeitig wärmeleitenden Platten (21) keramische Platten sind.

7. Vorrichtung nach einem der vorhergehenden Ansprüche, **dadurch gekennzeichnet, dass** die elektrischen Ein- und Ausgangsanschlüsse (15) in Einschubrichtung am hinteren Ende des modularen Einschubs (1) angeordnet sind.

8. Vorrichtung nach einem der vorhergehenden Ansprüche, **dadurch gekennzeichnet, dass** die Zündelektronik (14) jeweils im vorderen Bereich der modularen Einschübe (1) in Einschubrichtung vor der Thyristor-Anordnung (2) angeordnet ist.

9. Vorrichtung nach einem der vorhergehenden Ansprüche, **dadurch gekennzeichnet, dass** die Reihenschaltungen eines Kondensators mit einem Widerstand (17, 23) im hinteren Bereich der modularen Einschübe (1) in Einschubrichtung hinter der Thyristor-Anordnung (2) angeordnet ist, insbesondere mit Hilfe von Isolatoren (18) an die Stromschiene (15) angebunden.

10. Vorrichtung nach einem der vorhergehenden Ansprüche, **dadurch gekennzeichnet, dass** die Spannungsversorgung (19) für die Zündelektronik (14) im Einschub (1) integriert ist.

## Claims

1. Soft-start device having a housing and having at least one plug-in unit (1) which can be inserted in and withdrawn from the housing and which has a three-phase thyristor assembly (2), **characterised in that** the housing is provided with appropriate receptacles arranged one above another and/or one behind another for the modular plug-in units (1), the modular plug-in units (1) thus being able to be inserted in the heightwise or depthwise direction of the housing as desired and each modular plug-in unit being intended to supply a voltage, only a single module thus being required for each voltage level, and **in that** each plug-in unit can if required be connected in series or in parallel with other identical modular plug-in units (1) in order to create a complete voltage.

2. Device according to claim 1, **characterised in that** for each of the three phases (A, B, C), the thyristor assembly (2) of a plug-in unit (1) comprises a pair of thyristors (3A1, 3A2; 3B1, 3B2; 3C1, 3C2) connected in anti-parallel, with each thyristor (3A1, 3A2; 3B1, 3B2; 3C1, 3C2) being arranged between two heat-dissipating plates (4) and the two thyristors (3A1, 3A2; 3B1, 3B2; 3C1, 3C2) associated with a phase sharing one heat-dissipating plate (4).

3. Device according to claim 1 or 2, **characterised in that** all the thyristors (3A1, 3A2, 3B1, 3B2, 3C1, 3C2) associated with a voltage level are held in a linear stacked layout by a common clamping device (5).

4. Device according to claim 3, **characterised in that** insulating sheets (6), and in particular sheets of composite material, are arranged between the heat-dissipating plates (4) associated with two adjacent phases (A, B; B, C).

5. Device according to one of the preceding claims, **characterised in that** the modular plug-in units (1) are enclosed, and in particular are covered at the top and/or bottom, and as a particular preference in the region of the thyristor assembly (2), by sheets (21) which are electrically insulating and at the same time thermally conductive, and these sheets (21) have a sealed connection to the insulating sheets (6) to guard against electrical flashover.

6. Device according to claim 5, **characterised in that** the sheets (21) which are electrically insulating and at the same time thermally conductive are ceramic sheets.

7. Device according to one of the preceding claims, **characterised in that** the electrical input and output connections (15) are arranged at the rear end of the modular plug-in unit (1) in the direction of insertion.

8. Device according to one of the preceding claims, **characterised in that** each set of triggering electronics (14) is arranged in the front region of the modular plug-in units (1), in front of the thyristor assembly (2) in the direction of insertion.

9. Device according to one of the preceding claims, **characterised in that** the series circuits comprising a capacitor and a resistor (17, 23) are arranged in the rear region of the modular plug-in units (1), behind the thyristor assembly (2) in the direction of insertion, and in particular are connected to the bus-bar (15) with the help of insulators (18).

10. Device according to one of the preceding claims, **characterised in that** the voltage supply (19) for the set of triggering electronics (14) is incorporated in the plug-in unit (1).

## Revendications

1. Dispositif de démarrage progressif comportant un boîtier et au moins un insert (1) qui peut être inséré dans le boîtier et être extrait de celui-ci et qui comporte un système à thyristor triphasé (2), **caractérisé en ce que** le boîtier est équipé de logements correspondants disposés l'un au-dessus de l'autre et/ou l'un à côté de l'autre et destinés aux inserts modulaires (1) de sorte que les inserts modulaires peuvent être insérés sélectivement dans le sens de la hauteur ou de la profondeur du boîtier et chaque insert modulaire est destiné à générer une tension de sorte que, pour chaque niveau de tension, un seul module individuel est nécessaire et que chaque insert peut éventuellement être monté en série ou en parallèle avec d'autres inserts modulaires (1) identiques afin de former une tension totale.

2. Dispositif selon la revendication 1, **caractérisé en ce que** le système à thyristor (2) d'un insert (1) comporte pour chacune des trois phases (A, B, C) une paire de thyristors antiparallèles (3A1, 3A2 ; 3B1, 3B2 ; 3C1, 3C2), chaque thyristor (3A1, 3A2, 3B1, 3B2, 3C1, 3C2) étant disposé entre deux dissipateurs thermiques (4) et les deux thyristors (3A1, 3A2 ; 3B1, 3B2 ; 3C1, 3C2) d'une phase (A ; B ; C) se partagent un dissipateur thermique (4).

3. Dispositif selon la revendication 1 ou 2, **caractérisé en ce que** tous les thyristors (3A1, 3A2, 3B1, 3B2, 3C1, 3C2) d'un niveau de tension d'un réseau linéaire en forme de pile sont maintenus par un dispositif de serrage commun (5).

4. Dispositif selon la revendication 3, **caractérisé en ce que** des plaques isolantes (6), notamment des plaques en matériau composite, sont disposées entre les dissipateurs thermiques (4) de deux phases (A, B ; B, C) adjacentes.

5. Dispositif selon l'une des revendications précédentes, **caractérisé en ce que** les inserts modulaires (1) sont entourés, notamment recouverts au-dessus et/ou au-dessous, de façon particulièrement préférée dans la région du système à thyristors (2), par des plaques (21) électriquement isolantes et en même temps thermiquement conductrices et ces plaques (21) sont reliées aux plaques isolantes (6) de façon étanche vis-à-vis d'une décharge électrique.

6. Dispositif selon la revendication 5, **caractérisé en ce que** les plaques (21) électriquement isolantes et en même temps thermiquement conductrices sont des plaques en céramique.

7. Dispositif selon l'une des revendications précédentes, **caractérisé en ce que** les bornes électriques (15) d'entrée et de sortie sont disposées à l'extrémité arrière de l'insert modulaire (1) par référence au sens d'insertion.

8. Dispositif selon l'une des revendications précédentes, **caractérisé en ce que** l'allumage électronique (14) est disposé devant l'ensemble à thyristors (2) dans la région avant des inserts modulaires (1) par référence au sens d'insertion.

9. Dispositif selon l'une des revendications précédentes, **caractérisé en ce que** les circuits constitués d'un condensateur et d'une résistance (17, 23) en série sont disposés derrière le système à thyristors (2) dans la région arrière des inserts modulaires (1) par référence au sens d'insertion, notamment raccordés à la barre conductrice (15) par le biais d'isolateurs (18).

10. Dispositif selon l'une des revendications précédentes, **caractérisé en ce que** l'alimentation en tension (19) destinée à l'allumage électronique (14) est intégrée dans l'insert (1).
